Europäisches Patentamt

European Patent Office

Office européen des brevets

(11) Publication number: **0 407 329 A1**

# EUROPEAN PATENT APPLICATION

(21) Application number: 90630123.9

(22) Date of filing: 02.07.90

(51) Int. Cl.5: **G11C 17/06**

(30) Priority: 03.07.89 FR 8908900

(43) Date of publication of application:
09.01.91 Bulletin 91/02

(84) Designated Contracting States:
DE FR GB NL

(71) Applicant: YEDA RESEARCH AND
DEVELOPMENT COMPANY, LTD.
Weizmann Institute of Science Herzl Street
at Yavne Road P.O. Box 95
Rehovot 76100(IL)

(72) Inventor: Levy-Clement, Claude
28 Rue Marc Sangnier
F-92220 Bagneux(FR)
Inventor: Ryan, Margaret Amy
2759 Locksley Drive
Pasadena, California 91107(US)
Inventor: Tenne, Reshef
Hashomrim 21
Rehovot(IL)

(74) Representative: Waxweiler, Jean et al
OFFICE DENNEMEYER S.à.r.l. P.O. Box 1502
L-1015 Luxembourg(LU)

(54) Method of optically recording data, and semiconductor devices particularly useful therein.

(57) A method of recording data includes, photoetching selected areas of a semiconductor surface in accordance with the data to be recorded; and applying a thin electrically-conductive film over the semiconductor surface, including the photoetched selected areas, to produce enhanced-operation diodes at the photoetched areas outputting signals corresponding to the recorded data in response to excitation of the diodes. Also described is a silicon semiconductor having a photoetched surface producing enhanced operation of the semiconductor.

Fig. 1

EP 0 407 329 A1

## METHOD OF OPTICALLY RECORDING DATA, AND SEMICONDUCTOR DEVICES PARTICULARLY USEFUL THEREIN

The present invention relates to a method of optically recording data, and also to semiconductor devices particularly useful in such method.

Optical memories are made by recording the data to be stored in the form of optical images on a substrate in a manner enabling the recorded data to be retrieved by the change in the optical properties, primarily the coefficient of transmission or of reflection, produced as a result of optically recording the data. In retrieving the data, the substrate is scanned by a focussed excitation light source, such as a laser beam, and the light transmitted through the substrate, or reflected therefrom, is directed to a photoelectric detector or video camera which produces electrical signals corresponding to the data recorded on the substrate. The existing optical recording methods, however, are generally characterized by relatively poor spatial resolution, poor sensitivity of the photosensitive substrate to certain spectral regions, and/or high cost of the recording material.

An object of the present invention is to provide a novel method for optically recording data having advantages in the above respects. Another object is to provide an optical memory produced in accordance with the novel method. A further object is to provide a semiconductor signal translating device particularly useful as an optical memory.

According to the present invention, there is provided a method of optically recording data comprising: photoetching selected areas of a semiconductor surface in accordance with the data to be recorded; and applying a thin electrically-conductive film over the semiconductor surface, including said photoetched selected areas, to produce enhanced-operation diodes at said photoetched areas outputting electrical signals corresponding to said recorded data in response to excitation of the diodes.

The method may be used for producing optical memories based on either the photoelectric effect wherein the excitation is light and the output signals are electrical, or on the electroluminescent effect wherein the excitation is electrical (a voltage bias) and the output signals are light.

According to a further feature in the preferred embodiments of the invention described below, the method further comprises cleaning the semiconductor surface after photoetching the discrete selected areas and before applying the electrically-conductive film thereover.

A thin insulating film, e.g., silicon oxide or zinc sulphide, in the order of 10-50 Angstroms, may be applied to the etched semiconductor surface after cleaning.

As will be described more particularly below, the above method enables the production of optical memories having excellent spatial resolution, e.g., less than 1 $\mu$m, and having a high sensitivity in a broad spectral range, particularly in the near infrared region. Another advantage in the novel method is that it may be performed with simple setups and commonly-available materials. A still further advantage is that the memory may be based on the photoelectric effect to output electrical signals in response to light excitation, or on the electroluminescent effect to output light signals in response to electrical excitation, according to the particular application.

The invention also provides optical memories constructed in accordance with the above method. The invention may be used for producing two-dimensional optical memories, but is particularly useful in producing three-dimensional optical memories in the form of holographic gratings.

The above described method for making optical memories may use a large number of different semiconductors, generally having a bandgap of between 0.5 and 4 eV. Many examples are set forth below. However, surprisingly good results were obtained when the semiconductor was silicon.

Thus, when the photoetched semiconductor surface was silicon, it was surprisingly found that photoetching it (as distinguished from conventional chemical etching) produced a surface which was oxide-free and which remained oxide-free under ambient conditions for at least 24 hours. It was also surprisingly found that the photoetched silicon surface had a very low surface recombination velocity. Thus, whereas it is very difficult to obtain a surface recombination velocity of less than $10^4$ cm/sec in semiconductors in general, in this case when the silicon semiconductor was photoetched, a surface recombination velocity of less than $10^3$ cm/sec was observed.

The foregoing results produced when using photoetched silicon as the semiconductor greatly improved the response of the semiconductor to light or electrical excitation. However, these dramatically improved results produced by photoetching silicon semiconductor could also be advantageously used in many other applications of semiconductor signal translating devices.

According to another aspect of the present invention, therefore, there is provided a signal translating device comprising a silicon semiconductor having a photoetched surface.

Such photoetched silicon semiconductors are particularly useful when they include a thin electrically-conductive film over the photoetched surface to produce an enhanced-operation diode capable of outputting signals in response to excitation of the diode. Thus, such devices could be used as a radiation detector wherein radiation excitation causes the outputting of electrical signals, or as an electroluminescent device wherein electrical excitation causes the outputting of light.

Further features and advantages of the invention will be apparent from the description below.

The invention is herein described, by way of example only, with reference to the accompanying drawings, wherein:

Fig. 1 is a block diagram schematically illustrating one form of system for producing a three-dimensional optical memory in the form of a holographic grating in accordance with the present invention;

Fig. 2 is a block diagram illustrating a projection system for producing a two-dimensional or three-dimensional optical memory in accordance with the present invention;

Fig. 3 schematically illustrates one form of cell used in the photoetching step for producing the optical memory of either Figs. 1 or 2;

Figs. 4a and 4b are fragmentary views illustrating the production of two types of diodes in accordance with the present invention;

Fig. 5a illustrates an optical memory constructed to operate in accordance with the photoelectric effect, to output electrical signals in response to light excitation;

Fig. 5b illustrates an optical memory constructed to operate according to the electroluminscent effect, to output light signals in response to electrical (voltage bias) excitation;

Fig. 6 is a block diagram schematically illustrating one form of system for retrieving the data recorded in the optical memory produced in accordance with the invention using the photoelectric effect; and

Figs. 7, 8, 8a and 9 illustrate the spectral responses of optical memories constructed in accordance with several examples of the invention described below.

The invention is based on the known phenomenum, for example as described in US Patent 4,386,142, that photoetching a semiconductor improves its photoresponse. Thus, as described in the above patent, photoetching produces a substantially non-reflecting matte surface and also reduces surface recombination and reflection of the incident light, and thus photocurrent losses. When a semiconductor is illuminated in a photoetching setup including an electrolyte, the absorbed light produces electron-hole pairs which, in the absence of an electric field, diffuse into the bulk of the semiconductor until they recombine with each other. When an electric field is applied, however, the holes are drawn towards the semiconductor surface and cause a series of electrochemical corrosion reactions (photoetching) between the semiconductor and the electrolyte.

We have also noted, but not described in the above patent, that photoetching a semiconductor also improves its luminescence (intensity and/or spectrum) in response to electrical excitation.

The foregoing phenomena are exploited in the present invention to permit data, contained in the image directed onto the semiconductor during illumination, to be recorded on the semiconductor. Thus, by applying a thin electrically-conductive film over the photoetched areas of the semiconductor, a plurality of enhanced-operation diodes, having improved photoresponses or changed luminescence, are produced. Almost any type of information may thus be recorded to produce both two-dimensional and three-dimensional optical memories, particularly in the form of holographic gratings. By using a focussed light source (e.g., a laser beam) for excitation, the sound optical information may be converted to electrical signals; and by using a strong forward bias (e.g., one volt), the stored optical information may be converted to light signals. In both cases high spatial resolution is obtained in which the signals produced by the photoetched surface of the semiconductor are distinguishable from those produced by the non-photoetched surfaces.

The semiconductor substrate may be selected to have maximum sensitivity to a desired spectral range; and since semiconductor materials make very good substrates, the method also provides stability and permanence of the stored information with easy duplication.

The substrate may generally be in the form of a single crystal of the semiconductor material, polycrystalline or amorphous material. However, it is also possible to use a semiconductor substrate in the form of a thin film deposited, as by sputtering, spraying, vapour deposition, or electrochemical deposition, on a conducting support such as conducting glass.

The substrate may be made of a semiconductor known to have the property of controllable photocorrosion. Semiconductor materials having a bandgap between 0.5 and 4 eV possess this property at room temperature. The wavelength of illumination in producing the optical memory is chosen according to the material and the availability of a source of coherent illumination. The resolution and the spectral range of sensitivity to be obtained are dependent upon the material. In general, these materials may be compounds composed of an element from Column II of the Periodic Table (preferably Column IIa) and an element from Column VI. However, compounds composed of elements from Columns III and V, or elements (e.g., silicon, germanium) from Column IV, also yield good results. In addition, ternary compounds of the chalcopyrite structure may also be used. These materials permit recording with a source of infrared light. A sensitivity in the range 300 nm to 2.5 $\mu$m may thus be obtained. Under conditions where the semiconductorelectrolyte system is chilled, a sensitivity of up to 12 $\mu$m may be obtained.

The following table summarizes the properties of the principal semiconductors which may be used:

| MATERIAL | RESOLUTION OBTAINED | WAVELENGTH |
|---|---|---|
| | ($\mu$m) | (nm) |
| CdSe (crystal) | 0.4 | 514.5 |
| CdSe (film) | 0.5 | 632.8 |
| CdS | 0.2 | 441.6 |
| Si | 0.4 | 514.5 |
| $As_2Se_3$ | 0.4 | 632.8 |
| GaA1AsP | 0.5 | 632.8 |
| InP | 1.5 | 632.8 (488,441.6) |
| GaAs | 2.0 | 632.8, 257 |
| CdTe (crystal) | 1.0 | 632.8 |
| InSe | 40 | 632.8 |
| $WSe_2$ | - | 632.8 |
| HgCdTe | 1.0-12.0 | 1,000-12,000 |

As will be described more particularly below, unexpectedly good results were obtained when silicon was used as the semiconductor substrate.

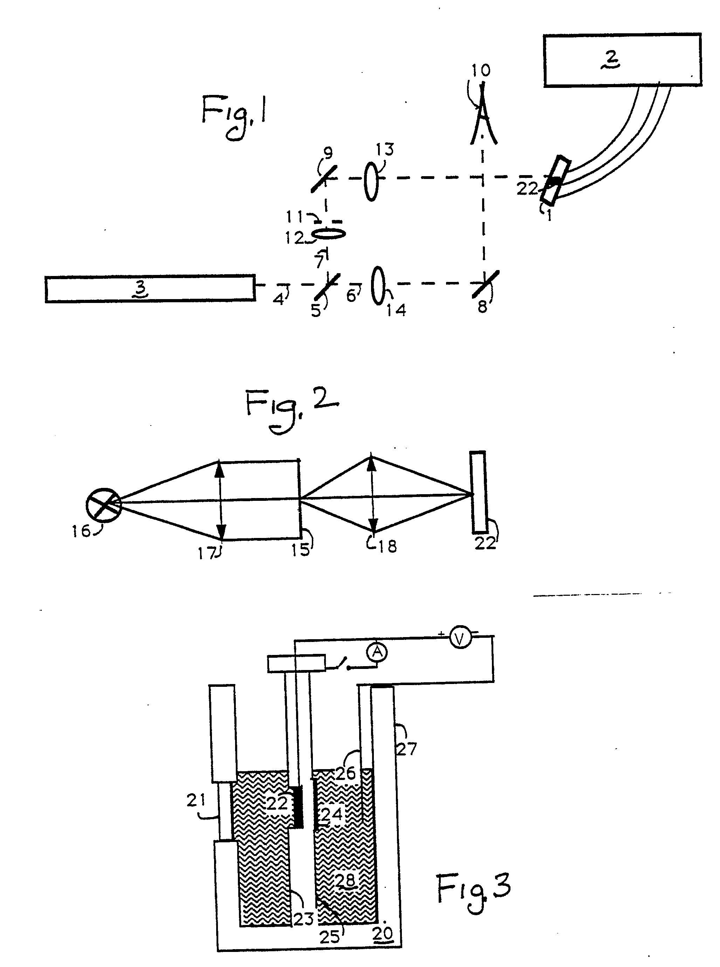

Fig. 1 illustrates a setup in which the data is recorded as a holographic pattern. The setup includes an electrochemical cell 1 (having the semiconductor substrate 22, as to be described more particularly below with respect to Fig. 3) on which the data is to be recorded under the control of a power supply or potentiostat system, generally designatd 2, by a laser source 3 outputting a laser beam 4 directed onto the substrate (22) in cell 1. The laser beam 4 exiting from the laser is split, by a semitransparent slide or beamsplitter 5, into two secondary beams 6 and 7 onto mirrors 8 and 9. Secondary beam 6, which will become the object beam, is expanded by a lens 14 to ensure that the object 10 is fully illuminated. Secondary beam 7, which becomes the reference beam, is directed through a spatial filter 11, this reference beam being expanded and collimated by lenses 12 and 13. After reflection from the object 10, the object beam 6 interferes with the reference beam 7 to produce an interferrogram on the surface of the substrate 22 of the cell 1.

Fig. 2 illustrates another setup in which the data, recorded on a conventional photographic film 15 or another semi-transparent object, is projected onto the subtrate (22) in cell 1. The film 15 contains zones which absorb more or less light according to the information recorded thereon, and is uniformly illuminated by the source 16 by using a condenser 17. An optical system 18 forms the image on the substrate 22.

Fig. 3 more particularly illustrates the electrochemical cell, e.g., cell 1 in Fig. 1. It comprises a watertight container 20 fitted with a window 21 through which the light image is formed on the substrate 22. The substrate 22 is held within the container 20 by a separate support 23. A counter-electrode 24 is fixed in the container by a support 25, and a reference electrode 26 is fixed on a wall 27.

The container 20 is filled with an electrolyte 28, for example 1 Molar hydrochloric acid (HCl), or 1 Molar perchloric acid ($HClO_4$), or 5% HF solution, or a neutral electrolyte (e.g., water with 1 Molar KCl). The data to be stored in the semiconductor substrate 22 is recorded by projecting light, e.g., via a mask and the cell window 21, onto the substrate 22. While the data is recorded on the substrate 22, a constant potential (e.g., 1 volt) is maintained between the reference electrode 26 and the substrate 22 which serves as the working electrode.

After recording the data on the substrate 22, the substrate is preferably cleaned according to a known procedure. For example, it may be alternatively immersed in solutions of dilute potassium cyanide (KCN) and rinsed with deionized water.

The substrate 22 is then covered with a thin film of an electrically-conducting material. A thin continuous film of gold of about 100 Angstroms thickness may be deposited, for example by an evaporation, sputtering or electroless technique. The film may also be indium oxide doped with tin (8-12%), or non-stoichiometric oxide.

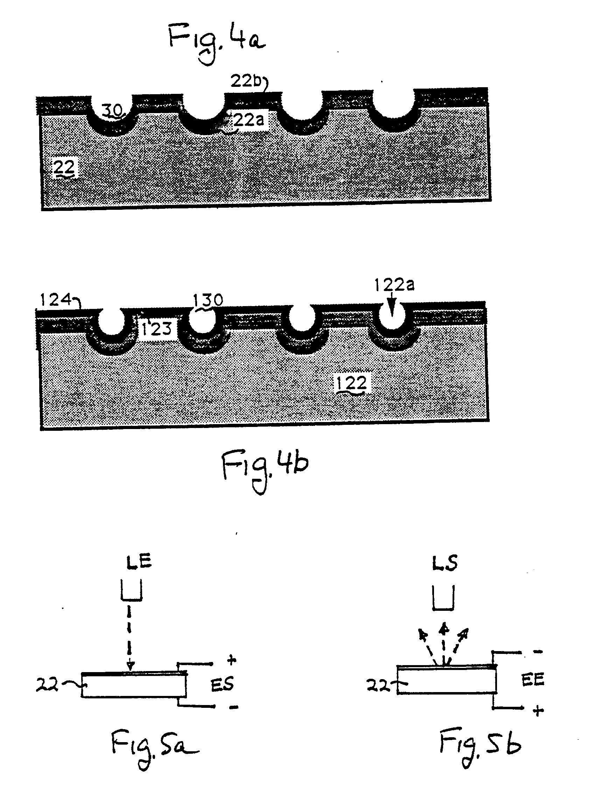

Fig. 4a illustrates several of the Schottky diodes constructed in accordance with the abovedescribed procedure. Thus, the semiconductor substrate 22 is etched in discrete selected areas 22a, in the manner described above, in accordance with the data to be recorded; and after cleaning, also in the manner described above, gold or other electrically-conductive and semitransparent material is applied as a continuous thin film 22b over the surface of the semiconductor substrate 22. While the metal-semiconductor interface produces a Schottky diode, each of the photoetched areas 22a defines a Schottky diode, generally designated 30, having a greatly improved photoresponse.

Fig. 4b illustrates a modification wherein the semiconductor substrate, therein indicated as 122, is selectively photoetched, as shown at 122a and covered by a thin insulating film 123, e.g., silicon oxide or zinc sulfide, of about 10-50 Angstroms thickness, before the semitransparent electrically-conductive (e.g., gold) film 124 is applied to form a plurality of MOS (metal oxide semiconductor) diodes 130.

A Schottky diode as illustrated in Fig. 4a, or MOS diode as illustrated in Fig. 4b, may be operated as a photoelectric device or as an electroluminescent device. Fig. 5a illustrates the device 30 operated according to the photoelectric effect, wherein a light excitation LE produces electrical signals (ES); whereas Fig. 5b illustrates the device 30 operated according to the electroluminescent effect, wherein electrical excitation EE (i.e., a voltage bias), outputs light signals LS.

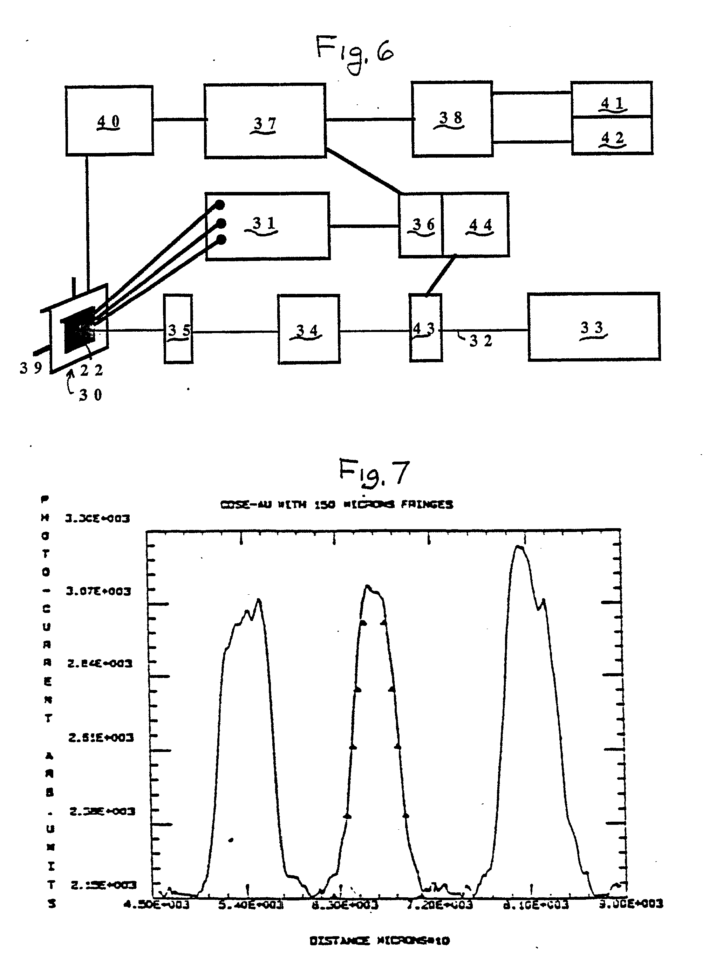

Fig. 6 is a block diagram illustrating a setup for retrieving the stored information by the photoelectric effect, i.e., by light excitation.

As shown in Fig. 6, the substrate 22, having recorded thereon the data in the form of a plurality of the enhanced-operation diodes 30, is connected to a voltage source 31 which maintains a constant voltage difference between the gold layer 22b and the etched faces 22a of the semiconductor substrate 22. This constant voltage is responsible for the polarization of the plurality of enhanced-operation Schottky diodes defined by the discrete etched areas 22a and the gold layer 22b.

The semiconductor substrate 22 is illuminated by a beam 32 emitted from a laser 33 which may be, for example, a continuous-wave helium-neon laser. The laser beam 32 is shaped and cleaned by the spatial filter 34. The optical system 35 focusses the laser beam 32 on the array of diodes 30. The current thus produced by the diodes depends on the properties of the areas on the diodes which are illuminated by the laser beam 32. The properties of these areas depend on the degree of photocorrosion effected at the selected areas 22a during the recording of the data on the semiconductor substrate 22.

The electrical signals produced by the Schottky diodes are transmitted by way of an output device 36 to an interface 37 which is linked to the computer system 38. The semiconductor substrate containing the diodes 30 is scanned by the laser beam 32. A linear translation system 39 may be provided to move the cell 30 on which the semiconductor substrate 22 rests with respect to the laser beam; alternatively, the laser beam 32 may be moved by an optical scanning system which causes the focal point of the laser beam to scan the semiconductor substrate 22 containing the diodes.

The translation system 39 is linked to a control unit 40 which determines the displacement and transmits information describing its position to the interface 37. The computer system 38 simultaneously receives two signals, namely: (1) an electrical signal via output device 36 corresponding to the photoresponse properties of the diode 30 of the semiconductor substrate 22 on which the laser beam is focussed; and (2) a signal corresponding to the location of the focussed beam on the semiconductor diodes.

The computer system 38 may be a microprocessor of known type. Preferably, it incorporates a plotter or chart recorder 41, and/or a printer 42, which produces graphical representation of the information recorded on the semiconductor substrates 22. The laser beam 32 is preferably modulated by a chopper 43 which is linked to a lock-in analyzer 44 receiving, by way of output device 36, the signals produced by the Schottky diodes 20 on the semiconductor substrate 22. The signal outputted by the lock-in analyzer 44 is fed into the interface 37.

As indicated earlier, the invention may use a wide variety of semiconductor substrates for producing the optical memory. Fig. 7 illustrates the photo response to laser excitation when using cadmium selenide (CdSe) as the semiconductor substrate and gold as the conductive semitransparent film to produce a plurality of improved diodes 30 (or 130). The laser excitation is a 2mW He-Ne laser beam used as a scanning light source.

As also indicated earlier, surprisingly good results were obtained when using silicon as the semiconductor substrate which was photoetched, as shown by the following further examples:

n-Type Si (Wacker): Sb doped ($10^{18}$ cm$^{-3}$) and P doped ($5 \cdot 10^{15}$ cm$^{-3}$) were used. Before use they

5

were chemically etched at 80°C by a mixture of $H_2O_2$(30%)/$H_2SO_4$ (ratio 1/4) for 10 min followed by a short etch in HF (48%). Photoetching was carried out in 5% HF solution under reverse bias of about 1 V vs. Pt electrode. Electroless deposition of Au, from gold chloride acid solution, was used for the fabrication of the Schottky diodes. It was found that Au deposition occurred only on surfaces which were prepolarized (between 0.1 and +1V vs. Pt) in 5% HF solution under reverse bias of about 1 V vs. Pt electrode. The thickness of the Au layer could be varied by changing the concentration of the gold chloride acid solution.

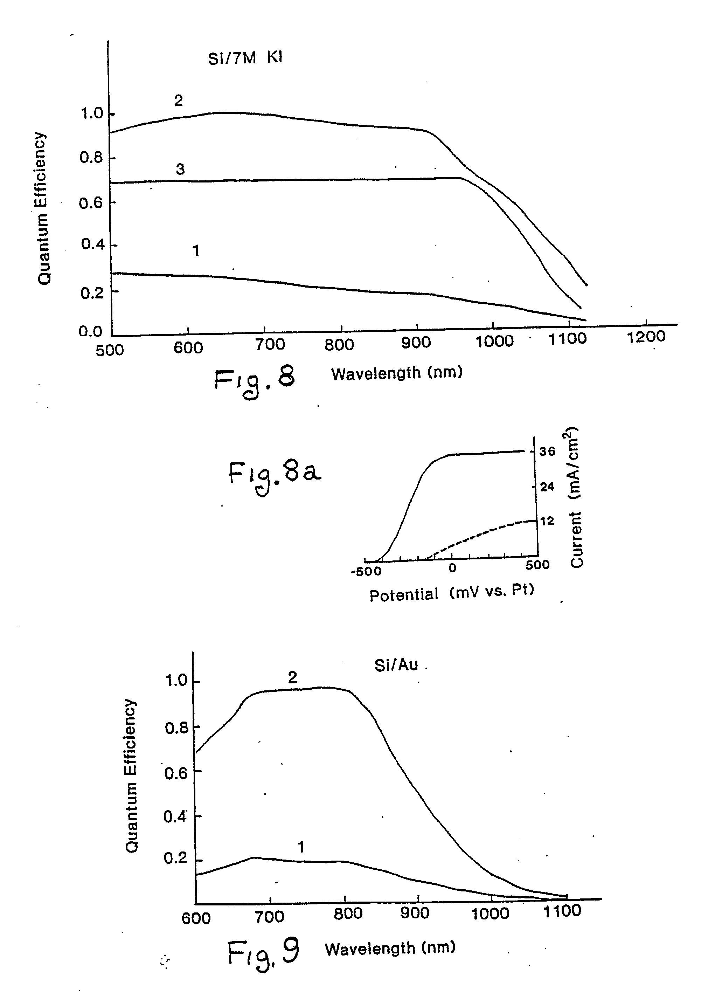

Fig. 8 illustrates the spectral response of n-Si (P doped) semiconductor in 7M iodide solution to which 1% HF was added to remove residual oxide which passivates the Si surface after prolonged irradiation. The current voltage (I-V) curve of the same electrode in this electrolyte is shown in Fig. 8a. Curve 1 of Fig. 8 shows the spectral response of a chemically etched silicon semiconductor. The photocurrent of this electrode under simulated AM1 illumination is shown in Fig. 8a (dashed curve). Curve 2 of Fig. 8, and full line curve of Fig. 8a, show the spectral response and photocurrent of the same electrode after photoetching, respectively. The quantum efficiency is close to 0.95 for a very broad spectral range, while the photocurrent (35MA/CM2) is close to the maximum achievable value from such semiconductor. For the sake of comparison the spectral response of the calibrated photodiode (curve 3) was added. Similar results were obtained for $S_b$-doped Si. The photoetching led to a quantum efficiency close to 0.95 over a broad spectral range and to photocurrents exceeding 35 mA/$cm^2$ for AM1 simulated illumination. Similar results were obtained for Sb-doped Si. The photoresponse of samples which were deliberately damaged, by polishing or by excessive etching, could be fully restored after that treatment. The rough surface produced by this process led to minimal reflection losses and to refraction of the incident light, which resulted in efficient collection of minority carriers produced by infrared excitation.

It was also found that the photoetched silicon surface was oxide-free and remained oxide-free for at least 24 hours under ambient conditions as evidenced by Auger surface spectroscopy.

The spectral response in the range of 880-1120 nm was simulated, and it was found that the surface recombination velocity was less than $10^3$cm/sec. This was also surprising since surface velocities of less than $10^4$cm/sec are generally recognized as being very difficult to obtain. While the foregoing results produced when photoetching silicon are advantageous in semiconductor signal translating devices in general, they are particularly advantageous in optical memories wherein light excitation produces output signals, as shown by the following additional data.

Fig. 9 illustrates the spectral response of n-Si (Sb doped)/Au Schottky barrier which was chemically etched on one part and photoetched on another part of the surface. For that purpose the entire sample area was prepolarized. Photoetching was performed only on part of the exposed surface using a He-Ne laser beam. Following that process, a gold layer was deposited from the gold chloride solution over the entire previously polarized area of the electrode. The photoresponse spectrum was corrected for the metal reflectivity and absorption using the measured transmissivity of a 200A gold layer, which was vapor deposited on glass. Here again a remarkable gain in the photoresponse was obtained by controlled photoetching (compare curve 1 of the chemically-etched surface with curve 2 of the photoetched surface). Similar gains were obtained for the phosphorous doped Si and with other metallic layers such as Pt. The fall off in the quantum efficiency for wavelengths between 820 and 950 nm was due to the experimental difficulty to fully take into account the transmissivity of the Au layer, at the onset of the plasmon absorption in the metal layer, which is less than 2%.

As also indicated earlier, the photoetching produces pronounced changes in the electroluminescence of the semiconductor junction, which enables the device also to be operated according to the electroluminescent effect to output light signals in response to electrical excitation, as described briefly above with respect to Fig. 6b. Following is an example illustrating the device operating according to the electroluminescent effect.

N-type CdS crystal was prepared as an electrode, i.e, ohmic contact was applied to the back surface, which was then attached to a metal substrate and encapsulated in an epoxy resin. Thereafter, a focussed laser beam was used for photoetching discrete areas of the semiconductor surface.

The electrode was dipped in a persulfate solution, which is well suited for the purpose of electroluminescence. The CdS electrode was biassed cathodically, and a visible luminescence was emitted from the semiconductor surface. The colour of the electroluminescence of the photoetched part was yellow, which is typical for a band-to-band recombination emitted from a clean surface. The chemically etched surface produced red luminescence, which is typical for an impurity related transition (luminescence).

Thus, by using a cut-on filter (ca 600 nm), the electroluminescence of the unetched part can be eliminated, and the electroluminescence of the photoetched part can be fed into a photomultiplier or video camera to read the information.

Alternatively, the surface may be scanned with a focussed laser beam to induce photoluminescence

6

from the surface, the colour and intensity of which will depend on the location of the beam.

Thus, the luminescence of the chemically etched and photoetched surface may be used for recording and retrieving data.

Further variations, modifications and applications of the invention will be apparent.

## Claims

1. A method of recording data, comprising: photoetching selected areas of a semiconductor surface in accordance with the data to be recorded; and applying a thin electrically-conductive film over the semiconductor surface, including said photoetched selected areas, to produce enhanced-operation diodes at said photoetched areas outputting signals corresponding to said recorded data in response to excitation of the diodes.

2. The method according to Claim 1, further comprising cleaning said semiconductor surface after photoetching said discrete selected areas and before applying the electrically-conductive film thereover.

3. The method according to either of Claims 1 or 2, wherein an insulating film is applied between the photoetched surface of the semiconductor and the electrically-conductive film.

4. An optical memory, comprising: a semiconductor having a surface photoetched on selected areas thereof in accordance with data to be recorded; and a thin electrically-conductive film over said semiconductor surface including said photoetched areas thereof to produce enhanced-operation diodes at said photoetched areas outputting signals corresponding to said recorded data in response to excitation of the diodes.

5. The optical memory according to Claim 4, further including an insulating film between the photoetched surface of the semiconductor and the electrically-conductive film.

6. A signal translating device comprising a silicon semiconductor having a photoetched surface.

7. The device according to Claim 6, further including said photoetched surface to produce an enhanced-operation diode capable of outputting signals in response to excitation of the diode.

8. The device according to Claim 7, further including light excitation means causing said diode to output electrical signals.

9. The device according to Claim 7, further including an electrical voltage biassing means for causing said diode to output light signals.

10. The device according to Claim 7, further including an insulating film between the photoetched surface of the silicon semiconductor and the electrically-conducted film.

Fig. 1

Fig. 2

Fig. 3

Fig. 4a

22b
30
22a
22

124
130
122a
123
122

Fig. 4b

LE

LS

22
+
ES
−

22
−
EE
+

Fig. 5a

Fig. 5b

# Fig. 6

# Fig. 7

COSE-AU WITH 150 MICRONS FRINGES

DISTANCE MICRONS*10

Si/7M KI

Quantum Efficiency

1.0 — 2

0.8

3

0.6

0.4 — 1

0.2

0.0

500   600   700   800   900   1000   1100   1200

Fig. 8   Wavelength (nm)

Fig. 8a

Current (mA/cm²)

36

24

12

-500   0   500

Potential (mV vs. Pt)

Si/Au

Quantum Efficiency

1.0 — 2

0.8

0.6

0.4

0.2 — 1

600   700   800   900   1000   1100

Fig. 9   Wavelength (nm)

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | IBM TECHNICAL DISCLOSURE BULLETIN, vol. 14, no. 1, June 1971, page 252, New York, US; F. GAENSSLEN: "Shottky barrier read-only memory" * The whole description * | 1 | G 11 C 17/06 |
| A | IBM TECHNICAL DISCLOSURE BULLETIN, vol. 20, no. 2, July 1977, page 588-589, New York, US; R. MOORE et al.: "Personalisation of ROS memories using a E-beam system" * The whole description * | 1 | |
| A | IEEE CONFERENCE ON INTEGRATED CIRCUITS, 2nd - 4th May 1967, pages 284-298, Eastborne, London, GB; R. STEWART: "Psin arrays-the complete optoelectronic function" * Page 286, lines 1-41; figure 3 * | 1 | |

TECHNICAL FIELDS
SEARCHED (Int. Cl.5)

G 11 C 17/06
G 11 C 11/36
G 11 C 7/00

The present search report has been drawn up for all claims

| Place of search | Date of completion of the search | Examiner |
|---|---|---|
| THE HAGUE | 11-10-1990 | DEGRAEVE L.W.G. |

EPO FORM 1503 03.82 (P0401)